# EUROPEAN PATENT APPLICATION

(11) **EP 1 503 401 A1**
(43) Date of publication of application: **02.02.2005**
(21) Application number: 03447206.8
(22) Date of filing: 01.08.2003
(51) Int. Cl.: H01L 21/00, B08B 7/00

(54) **Method and apparatus for cleaning a substrate by using a supercritical fluid**

(71) Applicant: VLAAMSE INSTELLING VOOR TECHNOLOGISCH ONDERZOEK (VITO), 2400 Mol (BE)
(72) Inventor: Weyten, Herman, 2100 Deurne (Antwerpen) (BE); Willems, Louis, 2480 Dessel (BE)
(74) Representative: Van Malderen, Joelle

(57) **Abstract**

The present invention is related to a method and apparatus for the cleaning of a substrate, in particular a semiconductor substrate. The method comprises the steps of introducing the substrate in a container, bringing said container into a given condition in terms of pressure and temperature, subjecting said substrate to a rotary movement, and spraying a supercritical fluid or a mixture of a supercritical fluid and a co-solvent onto the surface of said rotating substrate. The invention is equally related to an apparatus for performing the method of the invention.

## Description

### Field of the invention

The present invention is related to the cleaning of substrates, in particular semiconductor substrates, also called 'wafers', used for the production of micro-electronic devices.

### State of the art

During and after processing of silicon wafers, cleaning operations are of the utmost importance. It is crucial that grease and residues of for example an etching operation can be adequately removed from the surface of the wafer.

Different methods and apparatuses are known in the art. Some of these are based on the use of supercritical fluids, of which the cleaning capabilities have been known for some time and which are employed as an alternative to common wet processing. In particular, supercritical CO₂ has been widely used, mostly in conjunction with the use of a co-solvent or modifier.

In all of these known techniques, a substrate is introduced into a container, after which a supply of the supercritical fluid is added to said container under predefined pressure and temperature conditions, preferably together with a co-solvent. However, this approach is still lacking in cleaning efficiency.

Known techniques are described in the following prior art documents : US6067728, US2001/0050096, JP4017333.

### Aims of the invention

The present invention aims to provide a method and apparatus for the cleaning of a substrate which do not suffer from the drawbacks of prior art solutions.

### Summary of the invention

The present invention is related to a method for cleaning a flat surface of a substrate, said method comprising the steps of :
- placing said substrate into a container and closing off said container,
- pressurizing and heating said container,
- subjecting said substrate to a rotary movement,
- spraying a supercritical fluid onto said surface, from one or more spray nozzles.

According to the preferred embodiment, a mixture of a supercritical fluid and a co-solvent is sprayed onto said surface. Said spraying step is preferably performed from a plurality of nozzles.

The method of the invention may further comprise the step of adding a supercritical fluid through the wall of said container, i.e. not through the nozzles.

The invention is equally related to an apparatus for performing the method of the invention, said apparatus comprising :
- a container comprising a rotatable substrate support system,
- a supply conduit for a supercritical fluid,
- a supply conduit for a co-solvent, and
- at least one spray nozzle, said nozzle being connected to said supply conduit for said supercritical fluid.

According to the preferred embodiment of the apparatus of the invention, said spray nozzle is equally connected to said supply conduit for said co-solvent, and said supercritical fluid and said co-solvent are mixed at the outlet of said nozzle.

Further according to the preferred embodiment of the invention, said spray nozzle comprises an inner tube, for the flow of one of the two fluids, namely said supercritical fluid and said co-solvent, and an outer tube, which is coaxial with said inner tube, for the flow of the other of said fluids.

Said nozzle is preferably equipped with a needle valve for regulating the flow of co-solvent.

In an apparatus of the invention, said rotatable substrate support system preferably comprises :
- a rotatable disc, connected to a shaft, connected to a motor,
- a removable substrate holder, for being placed on said disc, said holder comprising a cavity into which fits a substrate.

### Short description of the drawings

Fig. 1 represents an overview of an apparatus according to the invention.

Fig. 2 represents a schematic view of a bank of nozzles.

Fig. 3 represents a detailed view of one nozzle.

Fig. 4 represents a detailed view of a substrate support system.

### Detailed description of the invention

The invention is related to a method for cleaning one or more substrates, in particular semiconductor substrates, wherein each substrate is subjected to a rotary movement inside a pressurized container, and wherein a supercritical fluid, or a mixture of a supercritical fluid and a co-solvent, is sprayed onto the surface of said rotating substrate, from at least one nozzle, preferably from a bank of nozzles which are able to spray said mixture onto the whole of the surface of the substrate or substrates. The rotation of the substrate, in combination with the spraying action allows a more efficient removal of contaminants from the substrate surface.

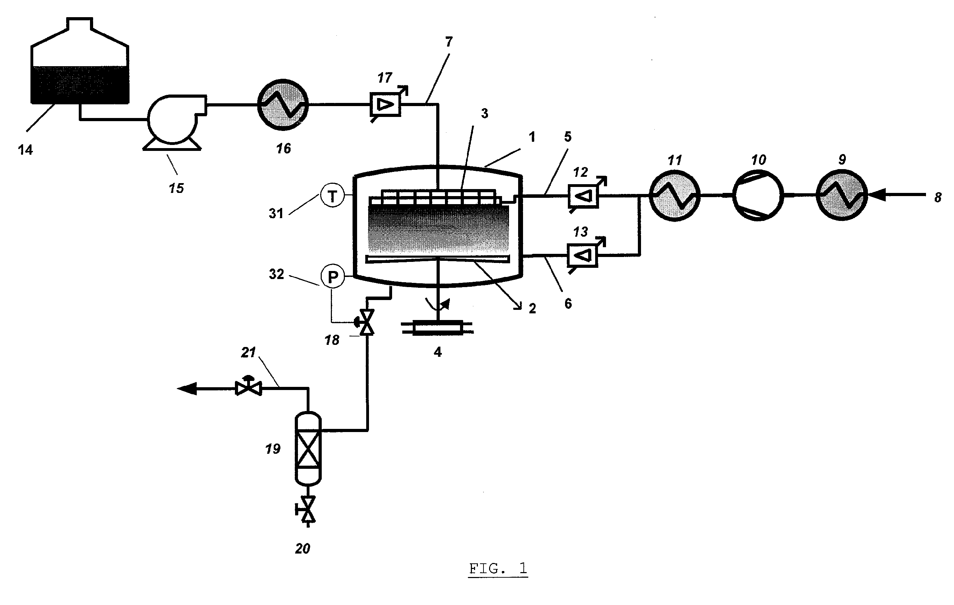

A preferred embodiment of an apparatus of the invention is shown in figure 1. The apparatus which is shown comprises a container 1 which is to work as a pressure chamber, comprising a substrate support system 2 and a bank 3 of injection nozzles. The apparatus of figure 1 is adapted for the treatment of one substrate. An apparatus of the invention may however be equipped with multiple substrate support systems in one pressure chamber, or with several pressure chambers, each with its own substrate support system, for the treatment of multiple substrates. The present description is however related to the one-substrate embodiment.

The substrate support system 2 is rotatable through a motor 4. The invention is characterized by the possibility to rotate the substrate and by the presence of the nozzles, which are able to spray a supercritical fluid (SCF), for example supercritical CO₂ (SCCO2), onto the substrate's surface, possibly mixed with a co-solvent.

The supercritical fluid is supplied through a conduit 5, equipped with a cooler 9, a compressor 10, a heater 11, and a flow meter and controller 12. Possibly, a bypass 6 may be present, equipped with a separate flow meter and controller 13, to inject SCF directly into the chamber 1. This separate SCF supply can be used to pressurize the chamber, to supply, if necessary a counter current SCF stream and/or to apply pressure pulses to help loosen particles on the substrate and break these particles up in sub-particles.

A co-solvent may be injected together with the supercritical fluid, due to a special design of the nozzles, described further on. The co-solvent is supplied from a tank 14, through a conduit 7, equipped with a liquid high pressure pump 15, a heater 16 and a flow meter and controller 17. The container 1 is equipped with a means 31 for measuring the temperature, and a means 32 for measuring the pressure inside the container.

The method of the invention comprises the steps of placing a substrate into the container 1, closing off said container, heating said container to the desired process temperature, through a heating means (not shown), and pressurizing the system to the desired process pressure by pumping in the supercritical fluid. The substrate is subjected to a rotation, and the supercritical fluid is then sprayed onto the rotating substrate surface, through the nozzles 30, possibly mixed with a co-solvent.

Depending on the type of supercritical fluid used, the temperature at which the supercritical fluid is introduced in the reactor lies between room temperature and 250°C. The pressure of the introduced SCF is between 35bar and 350bar.

Co-solvents which may be used are : alkanes (in particular hexane), alcohols such as methanol, ethanol, (iso)propanol. Other possible co-solvents are : acetone, acetonitrile, DMSO, NMP, DMF, DCM, MTBE or water. Because of the use of a supercritical fluid, the concentration of the co-solvent can be restricted to a maximum of 25% with respect to the supercritical fluid.

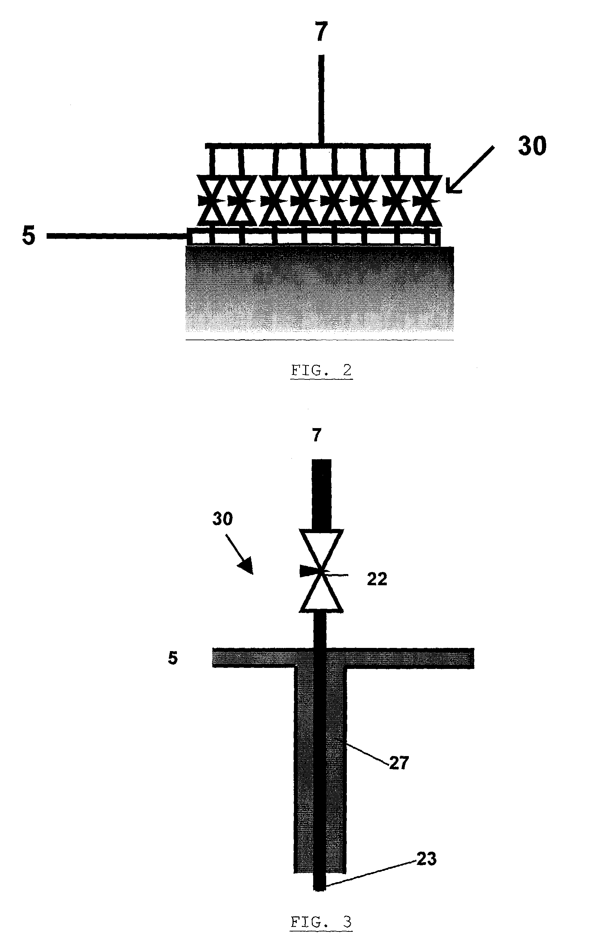

Figure 2 shows a schematic detailed view of the bank of nozzles. Each nozzle 30 supplies a stream of supercritical fluid or a mixture of the supercritical fluid and the co-solvent.

Figure 3 shows a detail of one nozzle 30. The flow of co-solvent can be regulated by a fixed or variable restrictor (e.g. a needle valve 22). The nozzle has a co-axial design. According to the preferred embodiment, the co-solvent is sprayed through the inner tube 23, which is in connection with conduit 7, while the supercritical fluid is supplied through the outer tube 27, which is in connection with conduit 5. It is however equally possible to supply the SCF through the inner tube 23 and the co-solvent through the outer tube 27. The needle valves 22 allow to regulate the amount co-solvent flow independently or shut off the co-solvent supply, if pure SCF needs to be used.

The pressure in the chamber is regulated by a pressure reduction valve 18 at the bottom of the chamber to avoid possible liquid build-up in the chamber. The outlet conduit further comprises a liquid recovery container 19, for recuperating the co-solvent at its outlet 20. The SCF is released into the atmosphere or recycled through conduit 21, equipped with a pressure reduction valve.

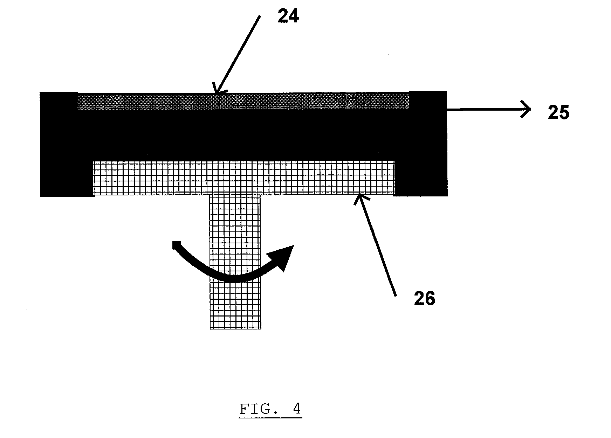

The substrate is preferably placed on a substrate support system 2, preferably made of stainless steel. A detail of such a system is shown in figure 4. The system comprises a removable substrate holder 25 to easily load and unload the substrates, and a shaft with a rotating disc 26 which is spun by the motor 4, at high speeds, e.g. 2000rpm, for homogenous cleaning. A cavity 24 is formed in the upper surface of the substrate holder 25, into which cavity a substrate fits exactly.

## Claims

1. A method for cleaning a flat surface of at least one substrate, said method comprising the steps of
- placing said substrate into a container (1) and closing off said container,
- pressurizing and heating said container,
- subjecting said substrate to a rotary movement,
- spraying a supercritical fluid onto said surface, from one or more spray nozzles.

2. The method according to claim 1, wherein a mixture of a supercritical fluid and a co-solvent is sprayed onto said surface.

3. The method according to claim 1 or 2, wherein said spraying step is performed from a plurality of nozzles.

4. The method according to any one of claim 1 to 3, further comprising the step of adding a supercritical fluid through the wall of said container, i.e. not through the nozzle or nozzles.

5. An apparatus for performing the method of any one of claims 1 to 4, said apparatus comprising :
- a container (1) comprising at least one rotatable substrate support system (2),
- a supply conduit (5) for a supercritical fluid,
- a supply conduit (7) for a co-solvent, and
- at least one spray nozzle (30), said nozzle being connected to said supply conduit (5) for said supercritical fluid.

6. An apparatus according to claim 5, wherein said spray nozzle (30) is equally connected to said supply conduit (7) for said co-solvent, and wherein said supercritical fluid and said co-solvent are mixed at the outlet of said nozzle (30).

7. An apparatus according to claim 6, wherein said spray nozzle comprises an inner tube (23), for the flow of one of the two fluids, namely said supercritical fluid and said co-solvent, and an outer tube (27), which is coaxial with said inner tube, for the flow of the other of said fluids.

8. An apparatus according to claim 6 or 7, wherein said nozzle (30) is equipped with a needle valve (22) for regulating the flow of co-solvent.

9. An apparatus according to claim 5, wherein said rotatable substrate support system (2) comprises :
- a rotatable disc (26), connected to a shaft (28), connected to a motor (4),
- a removable substrate holder (25), for being placed on said disc (26), said holder comprising a cavity into which fits a substrate.
